# EUROPÄISCHE PATENTSCHRIFT

(11) **EP 3 042 805 B1**
(45) Veröffentlichungstag und Bekanntmachung des Hinweises auf die Patenterteilung: **13.09.2017**
(21) Anmeldenummer: 15194964.1
(22) Anmeldetag: 17.11.2015
(51) Int. Cl.: B60R 16/03, G01R 31/00, H02H 3/20, H02J 1/08, G01R 31/02, G01R 31/08, G01R 31/12

(54) **VORRICHTUNG ZUM ÜBERWACHEN EINES BORDNETZES**
DEVICE FOR MONITORING AN ONBOARD NETWORK
DISPOSITIF DE SURVEILLANCE D'UN RÉSEAU DE BORD

(30) Priorität: 09.01.2015 DE 102015200174
(43) Veröffentlichungstag der Anmeldung: 13.07.2016
(73) Patentinhaber: ROBERT BOSCH GMBH, 70442 Stuttgart (DE)
(72) Erfinder: Haas, Wolfgang, 70439 Stuttgart (DE)

(56) Entgegenhaltungen:
- DE-A1- 10 141 504
- DE-A1- 19 616 293
- DE-A1-102008 048 702
- DE-A1-102009 012 078
- DE-A1-102010 062 038
- DE-A1-102013 211 742
- DE-C1- 10 210 665
- US-A1- 2014 092 724

## Beschreibung

### Stand der Technik

Die Erfindung geht aus von einer Vorrichtung zur Überwachung eines Bordnetzes nach der Gattung des unabhängigen Anspruchs. Eine gattungsgemäße Vorrichtung ist bereits aus der DE 101 41 504 A1 bekannt. Bei dieser Vorrichtung zum Erkennen eines Fehlerfalles bei Zwei- oder Mehrspannungsbordnetzen in einem Kraftfahrzeug unter galvanischer Trennung der Spannungsebene von Teilnetzen sind Überwachungsmodule und/oder eine Überwachungseinheit zur Isolationsüberwachung der Teilnetze untereinander vorgesehen. Bevorzugt ist dort zur Isolationsüberwachung ein hoher Innenwiderstand zwischen den Teilnetzen vorgesehen. Beispielsweise wird die Höhe des fließenden Prüfstromes gemessen, die dann das Maß für den Isolationswiderstand ist.

Aus der DE 10 2008 048 702 A1 ist eine Anordnung zum Identifizieren und/oder Untersuchen von Lasten in einem Bordnetz eines Kraftfahrzeugs bekannt. Dabei umfasst die Anordnung mindestens einen Stromsensor, der einem Knoten des Bordnetzes zugeordnet ist. Mit diesem mindestens einen Stromsensor ist ein durch den zugeordneten Knoten fließender Strom zu erfassen. Die im laufenden Betrieb des Kraftfahrzeugs im Bordnetz angeordneten Lasten werden anhand von abgreifbaren Signalen identifiziert und/oder untersucht.

Aus der DE 102 10 665 sind eine Vorrichtung zur Verteilung von elektrischer Energie und ein Verfahren zur Energieverteilungsüberwachung bekannt. Elektrische Verbraucher sind über Leitungen, an deren Enden Anschlussteilhälften angeordnet sind, mit Anschlussteilhälften der Verteileinheit verbindbar, wobei an den verbraucherseitigen Enden der Leitungen angeordnete Anschlussteilhälften mit Anschlussteilhälften der Verbraucher verbindbar sind, wobei die an die Leitungen angeschlossenen Anschlussteilhälften Leitungsbrücken aufweisen, welche dem Schließen oder Öffnen eines Leitungsabschnitts eines Diagnosestromkreises dienen und wobei zwischen der Energieerzeugungseinheit und der Verteileinheit ein Schaltmittel angeordnet ist, welches über eine Steuereinheit ansteuerbar ist und wobei dem Diagnosestromkreis ein Signalgenerator und eine Auswerteeinheit zugeordnet sind.

Aus der DE 10 2009 012 078 A1 sind eine Vorrichtung zur Verteilung von elektrischer Energie und ein Verfahren zur Energieverteilungsüberwachung bekannt. Hierbei ist ein Signalgenerator zur Erzeugung und Einspeisung eines Diagnosesignals als ein Generator zur Erzeugung und Einspeisung eines bidirektionalen pulsweiten modulierten unipolaren Spannungspuls-Signals in den Diagnosestromkreis ausgebildet und ein bidirektionales pulsweitenmoduliertes unipolares Spannungspuls-Signal wird als Stromschleifen geführtes Signal in den Diagnosestromkreis eingespeist und von zumindest einer Auswerteeinheit ausgewertet, wobei ein Fehlerzustand diagnostiziert wird, wenn eine Stromstärke des Diagnosesignals einen vorgegebenen Wert unterschreitet und/oder wenn eine Abweichung einer von der Auswerteeinheit ermittelten Periodendauer des Diagnosesignals eine vorgegebene Toleranzschwelle überschreitet.

Der Erfindung liegt die Aufgabe zugrunde, eine dauernde Überwachung der Entkopplung der Teilbordnetze zu ermöglichen, ohne den regulären Betrieb zu beeinträchtigen. Diese Aufgabe wird gelöst durch die Merkmale des unabhängigen Anspruchs.

### Vorteile der Erfindung

Die erfindungsgemäße Vorrichtung mit den Merkmalen des unabhängigen Anspruchs hat demgegenüber den Vorteil, dass störende Tests während des laufenden Betriebs des Fahrzeugs bezüglich einer Isolationsverletzung, insbesondere bei fehlertoleranten Bordnetzen, nicht mehr notwendig sind. Es ist auch nicht erforderlich, entsprechende Überwachungsphasen vor oder nach dem regulären Betrieb des Kraftfahrzeugs auszudehnen. Dies wird erfindungsgemäß dadurch möglich, dass in einem ersten Teilnetz ein Mittel zur Erzeugung eines charakteristischen Signals vorgesehen ist, welches dann über entsprechende Erfassungs- bzw. Auswertemittel im zweite Teilnetz auf Vorhandensein überprüft wird. Taucht trotz abgekoppeltem Zustand der beiden Teilnetze das charakteristische Signal des ersten Teilnetzes auch in dem zweiten Teilnetz auf, so wird auf eine Isolationsverletzung erkannt. Es können entsprechende Gegenmaßnahmen eingeleitet werden. Gerade bei fehlertoleranten Bordnetzen wird somit die Integrität sicher erkannt. Dies kann nun auch ohne kurzzeitige Abschaltung der Teilnetze erreicht werden, sodass nun die Energieversorgung in jedem Fall sichergestellt bleibt.

In einer zweckmäßigen Weiterbildung ist vorgesehen, dass als charakteristisches Signal ein langsamer Wechsel von zwei Spannungslagen des ersten Teilnetzes, vorzugsweise innerhalb des erlaubten Betriebsbereichs der Versorgungsspannung, gebildet wird. Somit kann das charakteristische Signal nach einer bestimmten bekannten Wartezeit, innerhalb der die Spannungslagen des charakteristischen Signals auch verändert wurden, über eine einfache Spannungsmessung ermittelt werden. Entsprechende Auswertemittel sind üblicherweise ohnehin im zweiten Teilnetz vorhanden. Damit ist der Zusatzaufwand für eine entsprechende Auswertung zur Erkennung einer Isolationsverletzung gering.

In einer zweckmäßigen Weiterbildung ist vorgesehen, dass als charakteristisches Signal ein höherfrequentes Signal, bevorzugt eine Sinusschwingung, erzeugt wird. Damit wird im Wesentlichen die Spannungslage der Versorgungsspannung im ersten Teilnetz nicht verändert. Hierzu ist im zweiten Teilnetz allerdings eine Auskoppeleinheit als Erfassungsmittel bzw. Auswertemittel notwendig, die ein höherfrequentes Signal in diesem Teilnetz erkennen kann. Jedoch kann die Frequenz in der gezielten Weise so vorgegeben werden, dass keine störenden Frequenzen erfasst werden.

In einer zweckmäßigen Weiterbildung ist vorgesehen, dass ein Gleichspannungswandler als Kopplungsmittel vorgesehen ist. Dieser Gleichspannungswandler erzeugt zudem das charakteristische Signal. Somit kann auf ohnehin vorhandene Komponenten zurückgegriffen werden, sodass der Zusatzaufwand für die entsprechende Isolationsüberwachung des Bordnetzes gering ausfällt.

In einer zweckmäßigen Weiterbildung ist vorgesehen, dass das Erfassungsmittel mit dem Auswertemittel über ein Bussystem kommuniziert. Somit kann das Auswertemittel dezentral angeordnet sein, bzw. durch ein für andere Zwecke vorgesehenes Steuergerät realisiert werden.

Weitere zweckmäßige Weiterbildungen ergeben sich aus weiteren abhängigen Ansprüchen und aus der Beschreibung.

### Zeichnung

Eine Vorrichtung zur Überwachung eines Bordnetzes ist in der Zeichnung dargestellt und wird nachfolgend näher beschrieben. Es zeigen:
die Figur 1 eine erste Bordnetztopologie,
die Figur 2 eine zweite Bordnetztopologie,
die Figur 3 den zeitlichen Verlauf eines ersten charakteristischen Signals sowie
die Figur 4 den zeitlichen Verlauf eines alternativen charakteristischen Signals.

Ein Basisbordnetz 10 umfasst einen Energiespeicher 16, zumindest einen Verbraucher 18, einen Starter 56 sowie einen Generator 58, die parallel zueinander gegen Masse verschaltet sind. Das Basisbordnetz 10 weist eine Versorgungsspannung U auf. In einem Teilnetz 20a sind ein weiterer Energiespeicher 34 und zuminest ein Verbraucher 22a parallel zueinander angeordnet und gegen Masse geschaltet. Das Teilnetz 20a ist über ein Kopplungsmittel 25, insbesondere ein Gleichspannungswandler, und einen ersten Pfad 21 mit dem Basisbordnetz 10 elektrisch verbunden.

In einem weiteren Teilnetz 20b sind ein weiterer Energiespeicher 36, ein weiterer Verbraucher 22b sowie ein Erfassungsmittel 40 zueinander parallel gegen Masse geschaltet angeordnet. Das Erfassungsmittel 40 kommuniziert über ein Bussystems 42 mit einem Auswertemittel 44. Das weitere Teilnetz 20b ist über ein weiteres Kopplungsmittel 27, insbesondere ein Gleichspannungswandler, und einen zweiten Pfad 23 mit dem Basisbordnetz 10 verbunden.

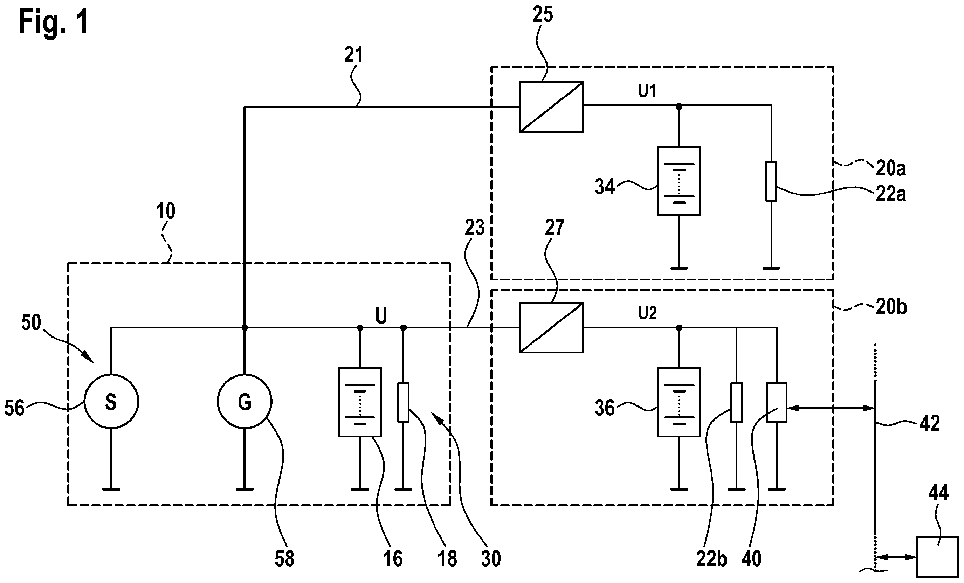

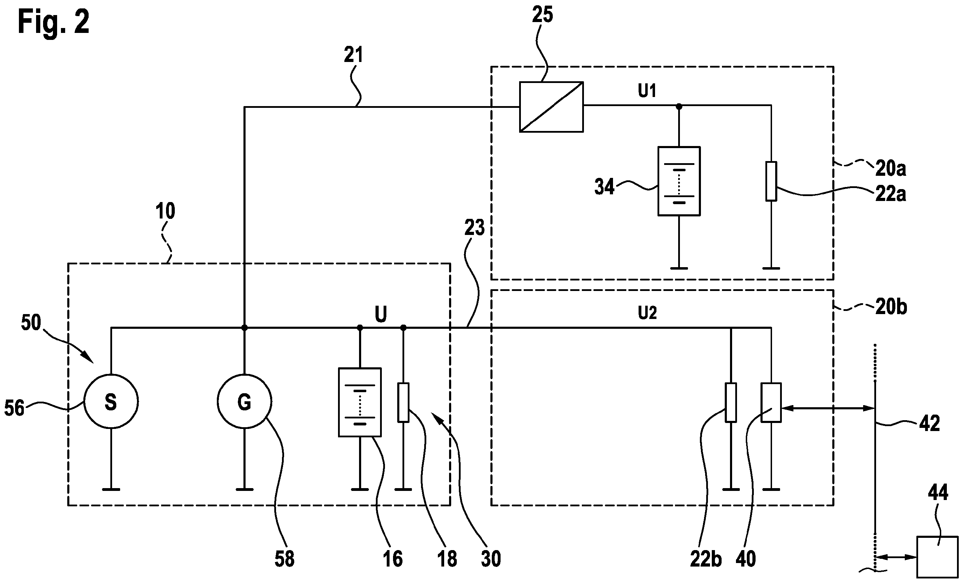

Das Ausführungsbeispiel gemäß Figur 2 unterscheidet sich von demjenigen nach Figur 1 darin, dass das weitere Teilnetz 20b lediglich von dem weiteren Verbraucher 22b und dem hierzu parallel geschalteten Erfassungsmittel 40 gebildet wird, jedoch kein Energiespeicher vorgesehen ist. Außerdem ist auch kein Kopplungsmittel 27 vorgesehen, sondern das weitere Teilnetz 20b ist über den zweiten Pfad 23 unmittelbar mit dem Basisbordnetz 10 verbunden.

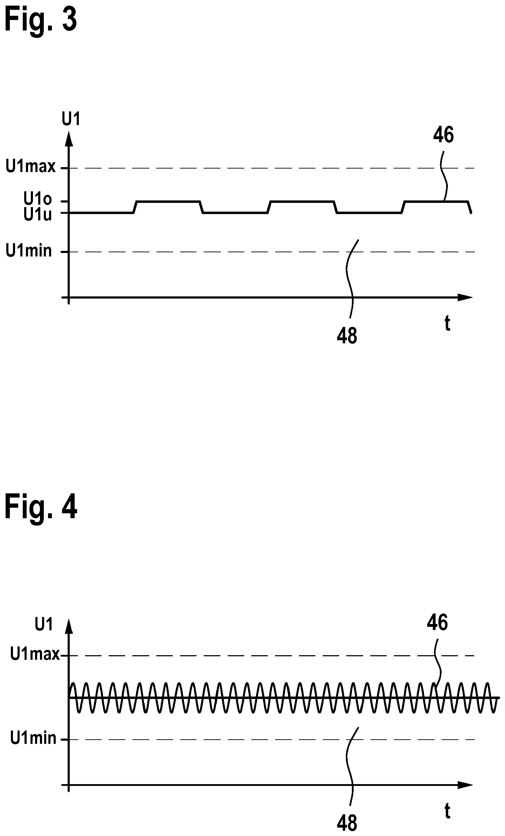

In der Figur 3 ist der zeitliche Verlauf eines charakteristischen Signals 46 gezeigt. Hierzu befindet sich die Teilnetzspannung U1 des Teilnetzes 20a, das dem charakteristischen Signal 46 entspricht, in einem erlaubten Bereich 48 der Versorungsspannung U1. Der erlaubte Bereich 48 liegt zwischen einem oberen Grenzwert Ulmax und einem unteren Grenzwert U1min. Das charakteristische Signal 46 wechselt zwischen zwei Spannungsniveaus U1u und U1o innerhalb des erlaubten Bereichs 48. Der Wechsel zwischen den beiden Spannungsniveaus U1u und U1o erfolgt relativ langsam mit einer großen Zeitkonstante, beispielsweise im Bereich von Sekunden bis Minuten.

Das charakteristische Signal 46 gemäß Figur 4 verläuft höherfrequent mit einer Sinusschwingung. Die Amplitude der Sinusschwingung liegt wiederum in dem erlaubten Bereich 48 der Versorgungsspannung U1. Die Frequenz der Schwingung liegt bevorzugt im Bereich von üblichen Regelbandbreiten von Spannungswandlern, z.B. mehrere 100Hz bis einige kHz. Der erlaubte Bereich 48 der Versorgungsspannung wird wiederum definiert durch einen oberen Grenzwert Ulmax und einen unteren Grenzwert U1min.

Die beschriebene Vorrichtung arbeitet wie folgt. Ein Mittel 25 zur Erzeugung des charakteristischen Signals 46 ist im ersten Teilnetz 20a angeordnet. Hierbei kann es sich beispielsweise um das Kopplungsmittel 25 handeln. Das Kopplungsmittel 25 ist beispielsweise als Gleichspannungswandler ausgeführt. Der Gleichspannungswandler 25 erzeugt nun eine Versorgungsspannung U1, die wie in Figur 3 dargestellt, zwischen unterem Niveau U1u und dem oberen Niveau U1o niederfrequent wechselt.

Im ordnungsgemäßen Betrieb des Bordnetzes soll das erste Teilnetz 20a keine Kopplung mit einem weiteren Bordnetzteil, beispielsweise dem Basisbordnetz 10 und/oder dem weiteren Teilnetz 20b, aufweisen. Im laufenden Betrieb erfasst nun das Erfassungsmittel 40 beispielsweise die am Verbraucher 22b abfallende Spannung U2. Das Erfassungsmittel 40 und/oder das Auswertemittel 44 detektieren nun, ob die erfasste Spannung U2 ebenfalls bestimmte Charakteristika des charakteristischen Signals 46 aufweisen. Hierzu wird beispielsweise ermittelt, ob innerhalb einer bestimmten Zeitkonstante typischerweise einige 100ms bis zu mehreren Sekunden, mit der auch das charakteristische Signal 46 Spannungspegel zwischen U1u und U1o ändert, in einem geänderten Spannungsniveau der zweiten Versorgungsspannung U2 niederschlägt. Erfolgt auch ein solcher zeitlicher Wechsel des Spannungsniveaus U2, so schließt das Auswertemittel 44 auf eine Isolationsverletzung. Entsprechende Gegenmaßnahmen können eingeleitet werden.

In einer alternativen Ausgestaltung gemäß Figur 4 wird als charakteristisches Signal 46 ein höherfrequentes Signal in dem ersten Teilnetz 20a erzeugt. So ist ein entsprechendes Mittel 25 zur Erzeugung des charakteristischen Signals 46 so mit dem ersten Teilnetz 20a verbunden, dass eine Einkopplung dort erfolgt. Solche Einkopplung kann erfolgen, wie bei den üblichen Power-Line-Kommunikationsmitteln. Nun ist beim Erfassungsmittel 40 bzw. Auswertemittel 44 vorgesehen, dass diese in dem entsprechenden Frequenzband eine Auskopplung des entsprechenden Höherfrequenzsignals vornehmen können.

Tauchen entsprechende Frequenzanteile, wie sie das charakteristische Signal 46 aufweist, nun auch in dem weiteren Teilnetz 20b bzw. dem Bordnetz 10 auf, so lässt sich auf eine Isolationsverletzung schließen. Das charakteristische Signal wird zum Beispiel durch eine feste Modulation des Spannungswandlers im ersten Teilnetz erzeugt. Alternativ kann über ein ähnliches Verfahren wie bei einer sog. Powerline-Communication ein Trägersignal über eine Koppelspule aufmoduliert werden. Die Auskopplung im zweiten Teilnetz erfolgt entsprechend in beiden Fällen über eine Auskoppelspule, der eine einfache Detektoreinheit (z.B. Gleichrichter) mit Spannungsmessung oder Schwellwertschalter nachgeschaltet ist.

Die beschriebene Vorrichtung eignet sich insbesondere zur Überwachung von Isolationsverletzungen eines Bordnetzes in einem Kraftfahrzeug. Insbesondere bei sicherheitsrelevanten Verbrauchern werden unterschiedliche Teilnetze gezielt herangezogen, um eine zuverlässige Energieversorgung gerade sicherheitsrelevanter Verbraucher zu ermöglichen. Somit eignet sich die zugehörige Überwachungsvorrichtung gerade für solche Bordnetztopologien. Sie ist jedoch hierauf nicht eingeschränkt.

## Patentansprüche

1. Vorrichtung zur Überwachung eines Bordnetzes, wobei das Bordnetz zumindest ein erstes Teilnetz (20a) mit einer ersten Spannung (U1) und ein weiteres Teilnetz (10, 20b) mit einer weiteren Spannung (U2) umfasst, wobei mit der ersten Spannung und mit der weiteren Spannung (U2) Verbraucher (18, 22a, 22b) versorgt sind, mit zumindest einem Kopplungsmittel (25, 27) zur trennbaren Verbindung der beiden Teilnetze (10, 20a, 20b, und wobei zumindest eines der Teilnetze (10, 20a, 20b) einen Energiespeicher (16, 34, 36) aufweist, mit zumindest einem Auswertemittel (44) zur Überwachung einer ordnungsgemäßen Isolation der beiden Teilnetze (10, 20a, 20b), **dadurch gekennzeichnet, dass** in dem ersten Teilnetz (20a) zumindest ein Mittel (25) zur Erzeugung eines charakteristischen Signals (46) vorgesehen ist, wobei in dem weiteren Teilnetz (10, 20b) zumindest ein Erfassungsmittel (40) angeordnet ist zur Erfassung der weiteren Spannung (U2), wobei das Auswertemittel (44) die weitere Spannung (U2) auswertet zur Erkennung, ob eine typische Größe des charakteristischen Signals (46) im weiteren Teilnetz (10, 20b) vorhanden ist.

2. Vorrichtung nach Anspruch 1, **dadurch gekennzeichnet, dass** das charakteristische Signal (46) durch einen Wechsel der ersten Versorgungsspannung zwischen einem oberen Pegel (U1o) und einem unteren Pegel (U1u) gebildet ist.

3. Vorrichtung nach einem der vorhergehenden Ansprüche, **dadurch gekennzeichnet, dass** das charakteristische Signal (46) durch einen höherfrequentes Signal gebildet ist, das der ersten Versorgungsspannung (U1) überlagert ist.

4. Vorrichtung nach einem der vorhergehenden Ansprüche, **dadurch gekennzeichnet, dass** das charakteristische Signal (46) die erste Versorgungsspannung lediglich innerhalb eines zulässigen Bereichs (48) verändert.

5. Vorrichtung nach einem der vorhergehenden Ansprüche, **dadurch gekennzeichnet, dass** das charakteristische Signal (46) durch ein Wechsel der ersten Versorgungsspannung zwischen einem oberen Pegel (U1o) und einem unteren Pegel (U1u) gebildet ist und der Wechsel mit einer Zeitkonstanten im Bereich von Sekunden bis Minuten erfolgt.

6. Vorrichtung nach einem der vorhergehenden Ansprüche, **dadurch gekennzeichnet, dass** das höherfrequente Signal eine Frequenz im Bereich zwischen mehreren 100Hz bis einigen kHz aufweist.

7. Vorrichtung nach einem der vorhergehenden Ansprüche, **dadurch gekennzeichnet, dass** als Mittel zur Erzeugung des charakteristischen Signals (46) ein Gleichspannungswandler (25) vorgesehen ist.

8. Vorrichtung nach einem der vorhergehenden Ansprüche, **dadurch gekennzeichnet, dass** das höherfrequente Signal eine Frequenz im Bereich einer Regelbandbreite des Gleichspannungswandlers (25) aufweist.

9. Vorrichtung nach einem der vorhergehenden Ansprüche, **dadurch gekennzeichnet, dass** das Erfassungsmittel (40) die an einem Verbraucher (22b) abfallende Spannung erfasst.

10. Vorrichtung nach einem der vorhergehenden Ansprüche, **dadurch gekennzeichnet, dass** das Erfassungsmittel (40) über ein Bussystem (42) mit dem Auswertemittel (44) kommuniziert.

## Claims

1. Apparatus for monitoring an onboard power supply system, wherein the onboard power supply system comprises at least one first subnetwork (20a) at a first voltage (U1) and a further subnetwork (10, 20b) at a further voltage (U2), wherein the first voltage and the further voltage (U2) are used to supply power to loads (18, 22a, 22b), having at least one coupling means (25, 27) for disconnectably connecting the two subnetworks (10, 20a, 20b), and wherein at least one of the subnetworks (10, 20a, 20b) has an energy store (16, 34, 36), having at least one evaluation means (44) for monitoring proper insulation of the two subnetworks (10, 20a, 20b), **characterized in that** the first subnetwork (20a) has at least one means (25) provided in it for generating a characteristic signal (46), wherein the further subnetwork (10, 20b) has at least one detection means (40) arranged in it for detecting the further voltage (U2), wherein the evaluation means (44) evaluates the further voltage (U2) in order to identify whether there is a typical magnitude of the characteristic signal (46) in the further subnetwork (10, 20b).

2. Apparatus according to Claim 1, **characterized in that** the characteristic signal (46) is formed by a change of the first supply voltage between an upper level (U1o) and a lower level (U1u).

3. Apparatus according to either of the preceding claims, **characterized in that** the characteristic signal (46) is formed by a higher-frequency signal that is overlaid on the first supply voltage (U1).

4. Apparatus according to one of the preceding claims, **characterized in that** the characteristic signal (46) alters the first supply voltage merely within an admissible range (48).

5. Apparatus according to one of the preceding claims, **characterized in that** the characteristic signal (46) is formed by a change of the first supply voltage between an upper level (U1o) and a lower level (U1u) and the change takes place with a time constant in the range of seconds to minutes.

6. Apparatus according to one of the preceding claims, **characterized in that** the higher-frequency signal has a frequency in the range between several hundred Hz and a few kHz.

7. Apparatus according to one of the preceding claims, **characterized in that** the means provided for generating the characteristic signal (46) is a DC-DC voltage converter (25).

8. Apparatus according to one of the preceding claims, **characterized in that** the higher-frequency signal has a frequency in the range of a control bandwidth of the DC-DC voltage converter (25).

9. Apparatus according to one of the preceding claims, **characterized in that** the detection means (40) detects the voltage dropped across a load (22b).

10. Apparatus according to one of the preceding claims, **characterized in that** the detection means (40) uses a bus system (42) to communicate with the evaluation means (44).

## Revendications

1. Dispositif de surveillance d'un réseau de bord, le réseau de bord comprenant au moins un premier réseau partiel (20a) ayant une première tension (U1) et un réseau partiel supplémentaire (10, 20b) ayant une tension supplémentaire (U2), des consommateurs (18, 22a, 22b) étant alimentés avec la première tension et avec la tension supplémentaire (U2), comprenant au moins un moyen de couplage (25, 27) servant à relier de manière amovible les deux réseaux partiels (10, 20a, 20b), et au moins l'un des réseaux partiels (10, 20a, 20b) possédant un accumulateur d'énergie (16, 34, 36), comprenant au moins un moyen d'interprétation (44) destiné à surveiller une isolation dans les règles de l'art des deux réseaux partiels (10, 20a, 20b), **caractérisé en ce que** dans le premier réseau partiel (20a) se trouve au moins un moyen (25) destiné à générer un signal caractéristique (46), au moins un moyen d'acquisition (40) étant disposé dans le réseau partiel supplémentaire (10, 20b) pour acquérir la tension supplémentaire (U2), le moyen d'interprétation (44) interprétant la tension supplémentaire (U2) afin de reconnaître si une grandeur typique du signal caractéristique (46) est présente dans le réseau partiel supplémentaire (10, 20b).

2. Dispositif selon la revendication 1, **caractérisé en ce que** le signal caractéristique (46) est formé par une variation de la première tension d'alimentation entre un niveau haut (U1o) et un niveau bas (U1u).

3. Dispositif selon l'une des revendications précédentes, **caractérisé en ce que** le signal caractéristique (46) est formé par un signal de fréquence plus élevée qui est superposé à la première tension d'alimentation (U1).

4. Dispositif selon l'une des revendications précédentes, **caractérisé en ce que** le signal caractéristique (46) ne modifie la première tension d'alimentation qu'à l'intérieur d'une plage admissible (48).

5. Dispositif selon l'une des revendications précédentes, **caractérisé en ce que** le signal caractéristique (46) est formé par une variation de la première tension d'alimentation entre un niveau haut (U1o) et un niveau bas (U1u) et la variation s'effectue avec une constante de temps dans la plage de quelques secondes à quelques minutes.

6. Dispositif selon l'une des revendications précédentes, **caractérisé en ce que** le signal de fréquence plus élevée possède une fréquence dans la plage entre plusieurs 100 Hz et quelques kHz.

7. Dispositif selon l'une des revendications précédentes, **caractérisé en ce que** le moyen présent pour la génération du signal caractéristique (46) est un convertisseur de tension continue (25).

8. Dispositif selon l'une des revendications précédentes, **caractérisé en ce que** le signal de fréquence plus élevée possède une fréquence dans la plage d'une largeur de bande de régulation du convertisseur de tension continue (25).

9. Dispositif selon l'une des revendications précédentes, **caractérisé en ce que** le moyen d'acquisition (40) acquiert la tension qui chute aux bornes d'un consommateur (22b).

10. Dispositif selon l'une des revendications précédentes, **caractérisé en ce que** le moyen d'acquisition (40) communique avec le moyen d'interprétation (44) par le biais d'un système de bus (42).
